# EUROPEAN PATENT SPECIFICATION

(11) **EP 1 570 496 B1**
(45) Date of publication and mention of the grant of the patent: **14.05.2008**
(21) Application number: 03721372.5
(22) Date of filing: 14.03.2003
(51) Int. Cl.: H01C 1/14, H01C 7/02

(54) **CONDUCTIVE POLYMER DEVICE AND METHOD OF MANUFACTURING SAME**
BAUELEMENT AUS LEITENDEM POLYMER UND VERFAHREN ZU SEINER HERSTELLUNG
DISPOSITIF POLYMERE CONDUCTEUR ET PROCEDE DE FABRICATION CORRESPONDANT

(30) Priority: 11.12.2002 US 432493 P
(43) Date of publication of application: 07.09.2005
(73) Proprietor: Bourns, Inc., Riverside, California 92507 (US)
(72) Inventor: BURKE, Ray, Co. Cork (IE); O'BRIEN, Maurice, Glanmire, Co. Cork (IE); LAN, Poting, Taipei (TW); CHU, Stelar, Ping-Cheng City, Tao-Yuan County (TW)
(74) Representative: Curley, Donnacha John
(86) International application number: PCT/US2003/007875
(87) International publication number: WO 2004/053899

(56) References cited:
- WO-A-99/27543
- FR-A- 2 790 136
- US-A- 4 912 450
- US-A- 5 884 391
- US-B1- 6 377 467

## Description

### BACKGROUND OF THE INVENTION

The present invention relates generally to the field of electronic devices. More specifically, this invention relates to positive temperature coefficient (PTC) devices that are designed for overcurrent protection and can be surface mounted in printed circuit board (PCB) applications.

It is well known that the resistivity of many conductive materials changes with temperature. For example, the resistivity of a PTC material increases as the temperature of the material increases. Examples of such a material are organic polymers, made electrically conductive by dispersing conductive fillers therein. These polymers generally include polyolefins such as polyethylene, polypropylene and ethylene/propylene copolymers. Conductive fillers include carbon black and metal powders.

Typically, a conductive polymer PTC device comprises a layer of conductive polymer PTC material sandwiched between upper and lower metal foil electrodes. The prior art includes single layer devices and multilayer devices, the latter comprising two or more conductive polymer layers separated by one or more internal metal foil electrodes, with external metal foil electrodes on the upper and lower surfaces. Examples of such devices and their methods of manufacture are disclosed in the following US patents, US 6,429,533; US 6,380,S39; US 6,377,467, US 6,242,997; US 6,236,302; US 6,223,423; US 6,172,591; US 6,124,751; US 6,020,808; and US 5,802,709.

At temperatures below a certain value, referred to generally as the critical or switching temperature, PTC materials of the type referred to above exhibit a relatively low, constant resistivity. However, as the temperature of the PTC material increases beyond the critical temperature, the resistivity of the material sharply increases with temperature. When the temperature of the material cools down below the critical or switching temperature, the resistivity reverts to its low, constant value. This effect has been used in the production of electronic PTC devices providing overcurrent protection in electrical circuits, where they are generally placed in series with a load.

There is an on-going trend in the electronics industry toward miniaturization, and in particular reduction of the physical size of the components. One way this has been achieved is the introduction of surface mount technology (SMT) components. In SMT components, the devices are soldered directly to the circuit boards, thus doing away with the space requirement for leads on devices and corresponding holes in the circuit boards. Still, as with other electronic applications, in SMT there is an on-going need to minimize the effective surface area or footprint of the devices. However, the operational requirements of PTC devices limit the degree to which the operational surface area of the PTC material can be reduced.

This need for an effective surface area based on the operational requirements of the devices is a major limiting factor in the design of small SMT PTC devices. For example, to maximize the effective surface area for a given footprint, the two electrical terminals for a PTC device may be positioned at opposing ends of the device. While this facilitates the full use of the surface area of the PTC material, the requisite soldering process occupies valuable space on a printed circuit board (PCB), effectively increasing the footprint of the PTC device.

A known solution to this problem is to position the two electrical terminals on the underside of the PTC device. This, however, requires that a connection be provided from the upper foil electrode layer of the PTC device to a terminal on the underside. This connection either significantly reduces the effective area of the PTC material or requires the use of a wrap around connection, which adds cost. For example, in US 6,292,088 a PTC device is disclosed in which an interconnection passes through the device. To prevent the interconnection shorting the two metal layers, a section of one of the metal layers adjacent to the interconnection is removed to provide an isolation barrier. However, the removal of this section significantly reduces the effective surface area of the PTC device, as the area of the metal layer removed to provide isolation equates approximately to the thickness of the PTC material. In addition, the area of metal that has been isolated, and the corresponding region of PTC material, serves no other purpose than to provide an electrical contact. US 6,377,467 discloses a PTC device having a pair of terminals on the underside of device. The terminals are positioned on-top of an insulating layer to isolate them from each other and also from underlying electrodes of the PTC material. Each of the terminals of the pair are connected to a corresponding terminal on the top side of the device by an interconnection. The interconnections also provide electrical connections to the electrodes of the PTC material. However, to prevent the interconnections shorting the two electrodes, a section of one of the metal electrodes adjacent to each interconnection is removed to provide an isolation barrier. Thus the effective area of the PTC device is significantly reduced. US-A-5 884 391 discloses an electrical device in which the eletrodes contacts are made through an insulative layer with contact points.

U.S. Patents 5,907,272 and 5,884,391 show examples of PTC devices in which the connection from the upper foil layer to a terminal on the underside is provided by a wrap-around conductor arrangement. This configuration makes an electrical connection by wrapping a conductive layer around the PTC material rather than wasting surface area of the PTC material in providing an interconnection. It is suggested however that the manufacturing methods of these patents may be inefficient and costly.

Accordingly, there is a need for an improved SMT PTC device, and a method for manufacturing it, in which the usable effective surface area of the PTC material within a given footprint on a PC board is maximized, and in which connections required to connect the upper electrode to the lower electrode use optimum area and at the same time do not reduce the effective area of the PTC material.

### SUMMARY OF THE INVENTION

In one aspect, the present invention provides a method of manufacturing an electronic device from a structure as defined by the features of claim 1. The structure comprises at least one layer of device material sandwiched between a first layer of metal and a second layer of metal. The method comprises the steps of forming a first aperture through the first layer of metal, the second layer of metal and the device material, applying a first layer of insulating material to the first metal layer, insulating the walls of the first aperture, providing a third metal layer on the first layer of insulating material, forming a second aperture within the region defined by the first aperture, providing a first electrical interconnection between the top and bottom surfaces of the through the second aperture, creating an electrical interconnection between the third metal layer and the first metal layer, selectively removing metal from the third metal layer to define first and second electrode areas, wherein the first terminal includes the electrical interconnection created between the third metal layer and the first metal layer and the second terminal includes the plated second aperture.

By using an insulated conductive channel to provide a path from one side of the device to the other, the effective surface area of the active material may be maximized, since only the area occupied by the channel is required to provide the interconnection between the upper and lower surfaces of the device.

The method may comprise the further steps of applying a second layer of insulating material on the second metal layer, and providing a fourth metal layer on the second layer of insulating material in advance of forming the second aperture.

The step of insulating the walls of the first aperture may be performed at least in part by the step of applying the first layer of insulating material to the first metal layer and/or by the step of applying the second layer of insulating material to the first metal layer,

In advance of the application of the insulating layers, a third aperture may be formed through the first metal layer, second metal layer and the at least one layer of device material subsequent to which a fourth aperture may be formed within the region defined by the third aperture. Whereupon the fourth aperture may be plated to provide a second electrical interconnection between the top and bottom surfaces of the device.

Third and fourth terminals may be defined using an additional step of selectively removing material from the fourth metal layer.

The first and third apertures may be formed at opposing ends of the device.

The method may include the initial step of defining singulation references in the first and second layers of metal.

Advantageously, the steps of applying the first layer of insulating material to the first metal layer and providing a third metal layer on the first layer of insulating material may be performed in a single step by the application of a resin clad metal, optionally copper.

Similarly, the steps of applying the second layer of insulating material to the second metal layer and providing the fourth metal layer on the second layer of insulating material may be performed in a single step by the application of a resin clad metal, optionally copper.

Optionally, the structure comprising at least one layer of device material sandwiched between a first layer of metal and a second layer of metal may be a multi layer structure comprising alternating layers of device material and metal.

The method of manufacturing a device is particularly suitable for the manufacture of PTC devices, and in which case the device material is a PTC material.

The structure comprising at least one layer of device material sandwiched between a first layer of metal and a second layer of metal may be provided as a laminated sheet.

In another aspect of the invention, an electronic device defined by the features of claim 11 is provided comprising a first metal layer, a second metal layer and at least one layer of device material sandwiched between the first metal layer and the second metal layer which function as electrodes for the device material. A first terminal is provided for a first electrical connection to the device and a second terminal is provided for a second electrical connection to the device, wherein the first terminal is electrically connected to the first metal layer and the second terminal is insulated from the first metal layer and electrically connected to the second metal layer by a conductive channel which passes through and is insulated from the first metal layer and device material. The conductive channel may be a metal plated channel.

The second terminal may be insulated from the first metal layer by a first layer of insulating material. This first layer of insulating material may substantially cover the first layer of metal.

A third layer of metal may be provided on the first layer of insulating material. This third layer may be divided by an isolation area to provide the first terminal and the second terminal.

The device may further comprise a third terminal for providing a third electrical connection to the device and a fourth terminal for providing a fourth electrical connection to the device, wherein the fourth terminal is electrically connected to the second metal layer and the third terminal is insulated from the second metal layer and electrically connected to the first metal layer by a second conductive channel which passes through and is insulated from the second metal layer and device material.

The second conductive channel may be a metal plated channel, which may be located at one end of the device. Moreover, the first conductive channel and the second conductive channel may be located at opposing ends of the device.

The second terminal may be insulated from the second metal layer by a second layer of insulating material, which may substantially cover the second layer of metal.

The fourth terminal may be electrically connected to the second metal layer by an interconnect formed through said second layer of insulating material.

The terminals of the device may be plated, optionally with nickel, copper and/or gold. The insulating material may comprise a cured resin. The at least one layer of device material may comprise alternating layers of device material and metal.

The device may be a PTC device and in which case the device material is a PTC material.

In an embodiment of the invention a PTC device is provided comprising:
a first metal layer, a second metal layer and at least one layer of PTC material sandwiched between the first metal layer and the second metal layer. A first terminal is provided as a first electrical connection to the device and a second terminal is provided as a second electrical connection to the device,
wherein the first terminal is electrically connected to the first metal layer and the second terminal is electrically connected to the second metal layer by a conductive channel which passes through and is insulated from the first metal layer and the at least one layer of PTC material.

In a further aspect of the invention, a method of manufacturing a matrix of electronic devices from a structure comprising at least one layer of device material sandwiched between a first layer of metal and a second layer of metal is provided, the method being defined by the features of claim 24. The method comprising the steps of forming a first array of apertures through the first layer of metal, the second layer of metal and the device material, applying a first layer of insulating material to the first metal layer, insulating the walls of the first array of apertures, providing a third metal layer on the first layer of insulating material, forming a second array of apertures such that each aperture of the second array is positioned within the region defined by an aperture from the first array of apertures, providing electrical interconnections between the top and bottom surfaces of the matrix through the second array of apertures to create electrical interconnections between the third metal layer and the first metal layer, selectively removing metal from the third metal layer to define first and second terminals for each device of the matrix, wherein each first terminal includes an electrical interconnection between the third metal layer and the first metal layer and each second terminal includes an insulated electrical interconnection between the top and bottom surfaces of the device.

The step of insulating the walls of the first array of apertures may be performed at least in part by the step of applying the first layer of insulating material to the first metal layer,

The method may comprise the further steps of: applying a second layer of insulating material on the second metal layer, and providing a fourth metal layer on the second layer of insulating material in advance of forming the second array of apertures.

Advantageously, the step of insulating the walls of the first array of apertures may be performed at least in part by the step of applying the second layer of insulating material to the first metal layer.

The method may comprise the further steps of forming a third array of apertures, in advance of the application of the insulating layers, through the first metal layer, second metal layer and the at least one layer of device material, forming a fourth array of apertures within the region defined by the third array of apertures, and providing electrical interconnections between the top and bottom surfaces of the device through the fourth array of apertures.

The method may comprise the additional step of selectively removing material from the fourth metal layer to define third and fourth terminals for individual devices in the matrix.

Each of the first array of apertures and each corresponding aperture of the third array of apertures may be formed on opposing ends of the individual devices within the matrix.

As an initial step singulation references may be defined in the first and second layers of metal.

Advantageously, the steps of applying a first layer of insulating material to the first metal layer and providing a third metal layer on the first layer of insulating material may be performed in a single step by the application of a resin clad metal, optionally copper.

Similarly, the steps of applying a second layer of insulating material to the second metal layer and providing a fourth metal layer on the second layer of insulating material may be performed in a single step by the application of a resin clad metal, optionally copper.

Optionally, the structure comprising at least one layer of device material sandwiched between a first layer of metal and a second layer of metal may be a multi layer structure comprising alternating layers of device material and layers of metal.

Where the device is a PTC device, the device material is a PTC material.

The method may comprise the additional step of joining a second matching matrix of electronic devices to the matrix such that terminals of adjoining faces of each matrix are aligned and electrically connected. As a final step, the devices may be singulated from the matrix.

As part of the singulation process, groups of two or more devices may be singulated together as individual devices. In this case, they may be configured as SIP or DIP packages.

The device material may be a dielectric material.

In a further aspect of the invention, a matrix of electronic devices is provided which is defined by the features of claim 26. It comprises a first metal layer, a second metal layer and at least one layer of device material sandwiched between the first metal layer and the second metal layer which function as electrodes for the device material. First and second arrays of terminals provide electrical connections to individual devices of the matrix, wherein the first array of terminals are electrically connected to the first metal layer and the second array of terminals are insulated from the first metal layer and electrically connected to the second metal layer by conductive channels which pass through and are insulated from the first metal layer and device material. The conductive channels may be metal plated channels. The second array of terminals may be insulated from the first metal layer by a first layer of insulating material, which may substantially cover the first layer of metal.

A third layer of metal may be disposed on the first layer of insulating material, here said third layer is divided by an array of isolation areas to provide the first array of terminals and the second array of terminals.

Third and fourth arrays of terminals may also provide electrical connections to individual devices. Moreover, the fourth array of terminals may be electrically connected to the second metal layer, and the third array of terminals may be insulated from the second metal layer and electrically connected to the first metal layer by a second array of conductive channels which pass through and are insulated from the second metal layer and material.

The second array of conductive channels may comprise metal plated channels. The second array of terminals may be insulated from the second metal layer by a second layer of insulating material which may substantially cover the second layer of metal.

The fourth array of terminals are electrically connected to the second metal layer by interconnects formed from through said second layer of insulating material.

Each of the array of second conductive channels is provided at an end of each device of the matrix moreover each of the array of first conductive channels and second conductive channels may located at opposing ends of each device of the matrix.

The terminals of the matrix may be plated, optionally with nickel, copper and/or gold.

The insulating material may comprise a cured resin.

The at least one layer of device material may comprise alternating layers of device material and layers of metal. Where the devices of the matrix are PTC devices the device material is a PTC material.

The invention extends to a stacked matrix comprising at least two matrices of the type described which are stacked on top of each other and in which corresponding terminals are electrically connected.

The above mentioned advantages of the present invention, as well as others, will be more readily appreciated from the detailed description that follows.

### BRIEF DESCRIPTION OF THE DRAWINGS

The invention will now be described with reference to the drawings in which:
FIG. 1 is a cross-sectional view of a portion of a laminated sheet from which the present invention is made;
FIG. 2 is a top plan view of the sheet portion shown in FIG. 1, after the step of forming a first array of apertures in the sheet;
FIG. 3 is a cross-sectional view taken along line X - X of FIG. 2;
FIG. 4 is a cross-sectional view, similar to that of FIG. 3, showing the result of a subsequent step in the process of the invention;
FIG. 5 is a cross-sectional view, similar to that of FIG. 4, showing the result of the next step in the process of the invention;
FIG. 6 is a cross-sectional view, similar to that of FIG. 5, showing the result of the next step in the process of the invention;
FIG. 7 is a cross-sectional view, similar to that of FIG. 6, showing the result of the next step in the process of the invention;
FIG. 8 is a cross-sectional view, similar to that of FIG. 7, showing the result of the next step in the process of the invention;
FIG. 9 is a cross-sectional view, similar to that of FIG. 8, showing a finished symmetrical PTC device according to the invention;
FIG. 10 is a cross-sectional view of a non-symmetrical embodiment of the PTC device of the invention;
FIG. 11 is a cross-sectional view of a multi-layer PTC device according to the invention;
FIG. 12 is a top view of an embodiment of the invention comprising four individual PTC devices packaged as a single multi-device component;
FIG. 13 is a top view of a SIP embodiment of the invention comprising an individual device;
FIG. 14 is a schematic representation of a line protection circuit suitable for implementation by devices of the invention;
FIG. 15 is a top view of an implementation of the schematic circuit of FIG. 14 according to the invention;
FIG. 16 is a side view of a matrix of devices;
FIG. 17 is a side view of the matrix of FIG. 16, illustrating a further step in a process of the invention;
FIG. 18 is a side view of the matrix of FIG. 17, illustrating a further step in a process of the invention; and
FIG. 19 is a side view of a singulated device formed from the matrix of FIG 18.

### DETAILED DESCRIPTION OF THE INVENTION

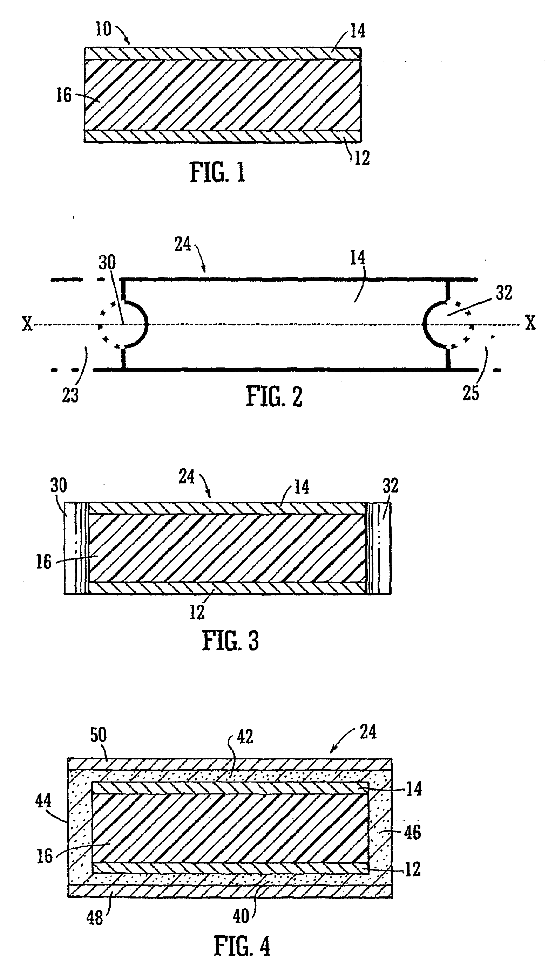

Referring now to the drawings, FIG. 1 illustrates a portion of a laminated sheet 10 that may be provided as an initial step in the process of manufacturing an electronic device in accordance with the present invention. The sheet 10 comprises two layers of metal foil 12, 14 and a region of active device material, for example conductive polymer PTC material 16. Specifically, the exemplary laminated sheet 10 shown comprises a layer of conductive polymer PTC material 16 sandwiched between a first or lower layer of metal foil 12 and a second or upper layer of metal foil 14.

The layer of conductive polymer PTC material 16 may comprise any suitable PTC material, including for example any suitable conductive polymer composition. An example of a suitable conductive polymer composition would be high density polyethylene (HDPE) into which is mixed an amount of carbon black that results in the desired electrical operating characteristics. An example of such a mixture is disclosed in WO97/06660, The metal layers 12, 14 may comprise any suitable metal, typically provided as a thin foil, with copper being preferred, although other metals, such as nickel and aluminum along with a number of alloys are also acceptable.

The laminated sheet 10 may be formed by any of several suitable processes that are well known in the art, as exemplified by the above referenced publication WO97/06660.

The present invention, in one aspect, is a manufacturing method or process comprising a series of processing steps performed upon the laminated sheet 10 to produce a matrix comprising a plurality of electronic devices. These steps will now be explained with reference to FIGS. 2 through 13.

An advantageous first step in the exemplary process is the definition, in the sheet 10, of an array of singulation lines (not shown), that define a matrix of sheet sections 23, 24, 25 (FIG. 2), each of which will be formed into an individual device, as described below. The fully formed individual devices will, at the end of the process described below, be singulated from the matrix along the singulation lines. The singulation lines may comprise a rectangular (X-Y) grid of lines formed by the selective removal of metal from the first layer 12 and/or second layer 14 of metal. The selective removal of this metal may be by any suitable process including standard printed circuit board assembly techniques employing photo-resist and etching methods well known in the art.

After the formation of the singulation lines, the next step in the process, illustrated in FIG. 2, is the formation of a first array of apertures 30, 32 in the laminated sheet 10. Each section 24 of the sheet to be singulated should have at least one aperture or share an aperture with an adjoining section. Any suitable PCB process including drilling, laser drilling, etching and punching may form the apertures 30, 32. The apertures provide openings from the top surface (upper metal layer 14) of the laminated sheet through to the lower surface (lower metal layer 12) of the laminated sheet.

The remaining steps of the process will be described with reference to this single section 24 defining an individual unit or device. It will be appreciated, however, that the subsequent process steps are intended to produce a matrix of devices from the laminated sheet 10 as a whole, and that the individual unit is only shown for clarity. In practice the individual unit is not singulated from the matrix until substantially all of the process steps have been completed.

As illustrated in FIG. 3, each of the apertures 30, 32 passes through the first metal layer 12, the layer of PTC material 16 and the second metal layer 14; i.e., the apertures 30, 32 define channels from the bottom surface of the laminated sheet 10 to the top surface. As illustrated in FIG. 4, after the apertures 30, 32 have been formed, a first layer of insulating material 40 is formed on or applied to the surface of the first layer 12 of metal. Similarly, a second layer of insulating material 42 is formed on or applied to the surface of the second layer 14 of metal. The insulating material is selected to ensure that it will flow into and substantially fill the apertures 30, 32, either directly or under pressure. These steps ensure that regions 44, 46 of insulating material substantially fill the apertures 30, 32. Although it is preferable that the apertures 30, 32 are replaced/filled by regions of insulating material, the primary purpose of the insulating material is to provide an insulating barrier to the walls defining the apertures 30, 32, i.e. the exposed edge surfaces of the first metal layer 12, the PTC material 16, and the second metal layer 14 defining the apertures. It will also be appreciated that a separate process may be used to provide an insulating barrier to the walls of the apertures distinct from the application of the first and second layers of insulation, i.e. using a separate process to fill the apertures 30, 32 with insulating material. However, this is a less preferred alternative as it introduces an additional step to the process.

The insulating material may be any suitable material, including plastic (e.g. epoxy resin). Fibers (e.g. glass) may be included within the insulating material to provide mechanical strength. In particular, the material referred to generally in the PCB industry as pre-preg, is an ideal insulating material. A preferred specific type of pre-preg for this application comprises a 1080 glass fabric (fiber glass) filled with a 62% resin content.

A third metal layer 48 is formed on or applied to the first layer of insulating material 40. Similarly, a fourth metal layer 50 is formed on or applied to the second layer of insulating material 42, resulting in the structure shown in FIG. 4. Suitable materials for the metal layers 48, 50 may include foils of copper, nickel, aluminum, and a number of alloys thereof. Such foils may be laminated or bonded to the respective insulating layers 40, 42. Deposition processes such as plating may also provide the third and fourth metal layers.

Advantageously, the steps of applying the layers of insulating material and metal may be combined into a single step through the use of resin clad metal materials, for example resin clad copper (RCC). The use of RCC allows the metal and insulating layers to be applied concurrently. A suitable RCC material would be a 1080 glass fabric impregnated with a 62% resin content and clad with copper. The adherence of the first and second insulating layers 40, 42 to the first and second metal layers 12, 14 respectively may be achieved by conventional PCB techniques, familiar to those skilled in the art.

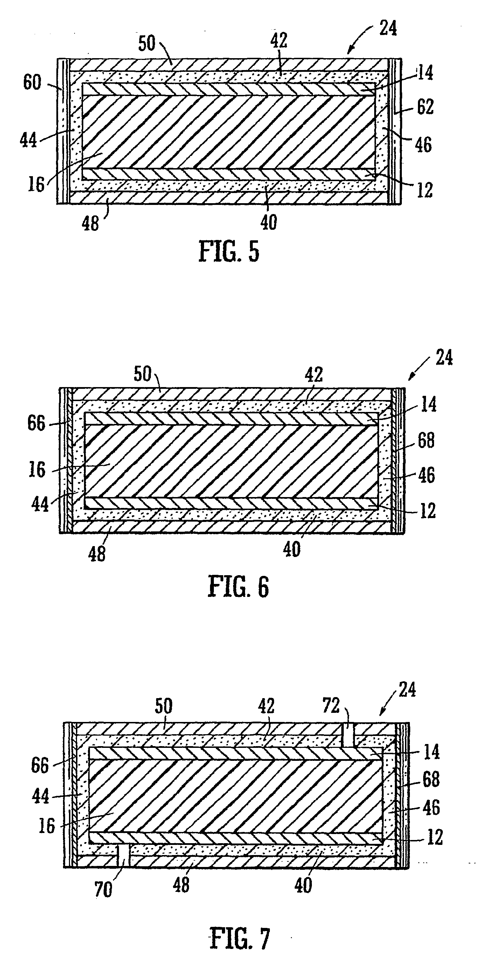

After the insulating layers 40, 42 and additional metal layers 48, 50 have been applied/ formed, a second array of apertures 60, 62 is defined/formed in the laminated sheet 10. Any suitable process including conventional drilling or laser drilling techniques may form these apertures. Each aperture 60, 62 of this second array is suitably formed within the boundary defined by a corresponding aperture 30, 32 of the first array of apertures, as illustrated in FIG. 5. The diameter of each of the apertures 60, 62 of the second array of apertures is less than the diameter of the apertures 30, 32 of the first array of apertures. The result of using smaller diameter apertures for the second array is that each of the apertures 60, 62 of the second array provides an insulated channel between the upper and lower surfaces of the laminated sheet 10 which is insulated from the first and second layers of metal 12, 14 and the layer PTC material 16. The insulating barrier 44, 46 for the channels is provided by the insulating material from the_first and second layers of insulating material which substantially filled the first array of apertures 30, 32.

The next step in the process, illustrated in FIG. 6, is to provide conductive paths between the third 48 and fourth 50 metal layers using each of the insulated channels provided by the apertures 60, 62 in the second array. That is, an array of external electrical interconnections 66, 68 is formed between the top and bottom surfaces of the sheet 10. These interconnections may be provided by any suitable process, including for example, plating (i.e. provision of a plated through-hole via) or the insertion of a conductive material. Examples of suitable conductive materials may include conductive epoxy or solder paste. A suitable plating process is an electroplating process. Suitably, in an electro-plating process, the third metal layer 48 is used as a first electrode and the fourth metal layer 50 is used as a second electrode for the plating process. The result, as shown in FIG. 6, is the provision of a pair of external conductive interconnections 66, 68 between the top and bottom surfaces of the laminated sheet 10 on opposite ends of each unit or section 24.

After forming the external conductive interconnections 66, 68, a first array of internal interconnections is formed between the fourth metal layer 50 and the second metal layer 14. Similarly, a second array of internal interconnections is provided between the third metal layer 48 and the first metal layer 12. These internal interconnections will provide conductive paths between the first metal layer 12 and the third metal layer 48, and between the second metal layer 14 and the fourth metal layer 50. As shown in FIG. 7, before an electrical connection between the first and third metal layers may be provided, a first array of openings or "micro-vias" 70 is formed from the lower surface of the sheet (the third metal layer 48) through to the surface of the first metal layer 12, while a second array of blind openings or "micro-vias" 72 is formed from the upper surface of the of the sheet (the fourth metal layer 50) through to the surface of the second metal layer 14. Suitable methods for forming these blind openings or micro-vias 70, 72 include laser drilling and etching.

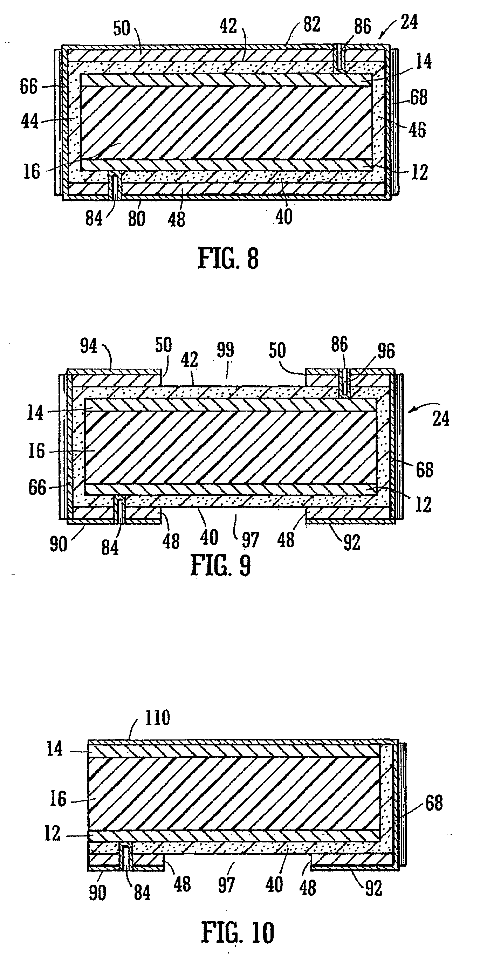

Once the micro-vias 70, 72 have been formed, the internal electrical interconnections may be established through the micro-vias by disposing conductive material within them. The preferred method of providing the conductive material is a conventional plating process, such as electroplating or electroless plating. The electrical connections may also be provided by inserting a conductive material, for example conductive epoxy or solder paste, into the micro-vias 70, 72. Assuming a suitable plating process is used, FIG. 8 shows a lower plating layer 80 and an upper plating layer 82 deposited over the third and fourth metal layers 48, 50 respectively. The plating layers 80, 82 fill the micro-vias 70, 72, respectively, forming lower and upper internal conductive interconnections 84, 86, respectively, within the micro-vias 70, 72. As a result of this plating, a continuous path of conductive metal is formed from the first metal layer 12, through the lower internal interconnection 84, the lower plating layer 80, the first external interconnection 66, the upper plating layer 82, and the second external interconnection 68. A conductive path is also established between the second metal layer 14 to the upper plating layer 82 through the upper internal interconnection 86, as shown in FIG. 8.

At this point it is necessary to form two separate, electrically isolated conductive paths so as to provide a first terminal that electrically connects the first metal layer 12 to the upper plating layer 82, and a second terminal, electrically isolated from the first terminal, that electrically connects the second metal layer 14 to the lower plating layer 12. The formation of the first and second terminals for subsequent use as connection points for the PTC devices is shown in FIG 9. The lower plating layer 80 and the third metal layer 48 are masked and selectively etched away to form lower isolation areas 97 on the lower surface of the sheet 10 that are devoid of metal and that divide the third metal layer 48 and the lower plating layer 80 of each unit 24 into separate first and second lower terminal pads 90, 92 (i.e. the areas at each end of the unit where the third metal layer has not been removed). This selective removal may be performed by any suitable process, including, for example, standard photo-resist and etching techniques. Similarly, the upper plating layer 82 and the fourth metal layer 50 are masked and selectively etched away to form upper isolation areas 99 on the upper surface of the sheet that are devoid of metal and that divide the fourth metal layer 50 and the upper plating layer 82 of each unit 24 into separate first and second upper terminal pads 94, 96.

The two lower terminal pads 90, 92 are suitably positioned in regions adjacent the opposite ends of the device or unit 24, and they are respectively connected to the corresponding upper terminal pads 94, 96 by the respective insulated conductive channels that respectively form the external interconnections 66, 68. Furthermore, the first metal layer 12 is electrically connected to the first lower terminal pad 90 by the lower internal interconnection 84, while second metal layer 14 is electrically connected to the second upper terminal pad by the upper internal interconnection 86. Thus, a first terminal is formed, comprising the first lower terminal pad 90, the first external interconnection 66, and the first upper terminal pad 94, which terminal provides electrical connection to the first metal layer 12, which thereby forms a first electrode. Likewise, a second terminal is formed, comprising the second lower terminal pad 92, the second external interconnection 68, and the second upper terminal pad 96, which terminal provides electrical connection to the second metal layer 14, which thereby forms a second electrode. This results in a symmetrical PTC device 24 which, when singulated from the sheet 10 (i.e., the overall matrix of devices), may used directly as an SMT PTC device. Suitable techniques for singulation are well known in the art and include routing, guillotining, dicing, punching, laser cutting and scouring.

In particular, the process described above produces a matrix comprising a plurality of laminar PTC devices which may be singulated from the original matrix. Each of the PTC devices comprises a first or lower electrode 12 formed from the first metal layer 12, and a second or upper electrode 14 formed from the second metal layer 14. A layer of PTC material 16 is sandwiched between these first and second electrodes 12, 14. The first electrode 12 is substantially covered by a first layer 40 of insulating material. Similarly, the second electrode 14 is substantially covered by a second layer of insulating material 42. A third metal layer 48 is provided on the first insulating layer 40. The third metal layer 48 is divided to form first and second lower terminal pads 90, 92 on the underside of the device. The two lower terminal pads are positioned in regions adjoining opposing ends of the PTC device. The first lower terminal pad 90 is connected to the first electrode 12 by the first internal interconnection 84 that passes through the first layer of insulating material 40. The second lower terminal pad 92 is separated from the first lower terminal pad 90 by the lower isolation area 97 where the third metal layer 48 has been selectively removed, and it is insulated from the first electrode 12 by the first layer of insulating material 40.

Likewise, the fourth metal layer 50 is divided by the upper isolation area 99, where metal has been selectively removed, to provide the first and second upper terminal pads 94, 96. The first and second upper terminal pads 94, 96 are positioned in regions adjoining opposing ends of the PTC devices. Suitably, the positioning of the first and second upper terminal pads 94, 96 corresponds directly to positioning of the first and second lower terminals 90, 92, respectively. In other words, the first upper terminal pad 94 is formed on the opposing side of the PTC device to the first lower terminal pad 90, and the second upper terminal pad 96 is formed on the opposing side of the PTC device to the second lower terminal pad 92.

The second upper terminal pad 96 is connected to the second electrode 14 by the second or upper internal interconnection 86 that passes through the second layer of insulating material 42. The first upper terminal pad 94 is separated from the second upper terminal pad 96 by the upper isolation area 99 where metal has been selectively removed, and it is insulated from the second electrode 14 by the second layer of insulating material 42.

The first lower terminal pad 90 is electrically connected to the first upper terminal pad 94 by the first conductive external interconnection 66, which passes through and is insulated from the first and second electrodes 12, 14 and the layer of PTC material 16. Similarly, the second lower terminal pad 92 is connected to the second upper terminal pad 96 by the second conductive external interconnection 68, which passes through and is insulated from the first and second electrodes 12, 14 and the layer of PTC material 16. It will be appreciated that the resulting PTC device comprises two paired arrangements of terminal pads on opposing sides of the PTC device. The effective resistance between the terminal pads in each pair is that of the PTC material (as contact and interconnect resistances are small in comparison, particularly when the PTC material is in a tripped state).

By using insulated conductive channels to provide the external interconnections 66, 68 from one side of the PTC device to the other, the effective surface area of the PTC material utilized by the device may be maximized.

The above described process results in a symmetrical PTC device that facilitates easy placement without the need for correct orientation of the device beforehand.

Of particular advantage is that the PTC devices are manufactured using techniques that are commonplace in the reasonably low cost manufacturing environment of the PCB industry. The above described process has been described with reference to the production of a symmetrical PTC device having a single layer of PTC material. It will be appreciated that - further embodiments are possible. For example, a non-symmetrical device, i.e. where the device will only function correctly when placed with the underside down, may be provided by the omission of a number of the steps in the above described process and correspondingly the omission of a number of the features in the above described PTC device. In particular, the requirement for a second external interconnection provided by an insulated channel, a fourth metal layer and a second layer of insulating material may be obviated as illustrated in the exemplary structure of FIG. 10. In particular, a non-symmetrical laminar PTC device may be provided, comprising a first laminar metal electrode 12 and a second laminar metal electrode 14. A layer of PTC material 16 is sandwiched between these first and second electrodes 12, 14. The first electrode 12 is substantially covered by a first layer of insulating material 40. A third layer of metal 48 is provided on the first layer of insulating material 40. The over-plated third layer of metal 48 is divided by an isolation area 97 to form first and second lower terminal pads 90, 92. The two terminal pads are positioned in regions adjoining opposing ends of the PTC device. The first terminal pad 90 is connected to the first electrode 12 by an internal conductive interconnection 84 formed through an opening or micro-via that passes through the first layer of insulating material 40. The second terminal pad 92 is separated from the first terminal pad 90 by the isolation area 97 where the over-plated third metal layer 48 has been selectively removed, and it is insulated from the first electrode 12 by the first layer of insulating material 40.

The second terminal pad 92 is electrically connected to the second electrode 14 by a conductive channel that forms an external interconnection 68, formed as described above (with modifications to account for the absence of the second insulating layer and fourth metal layers), which passes through and is insulated from the first and second electrodes 12, 14 and the layer of PTC material 16.

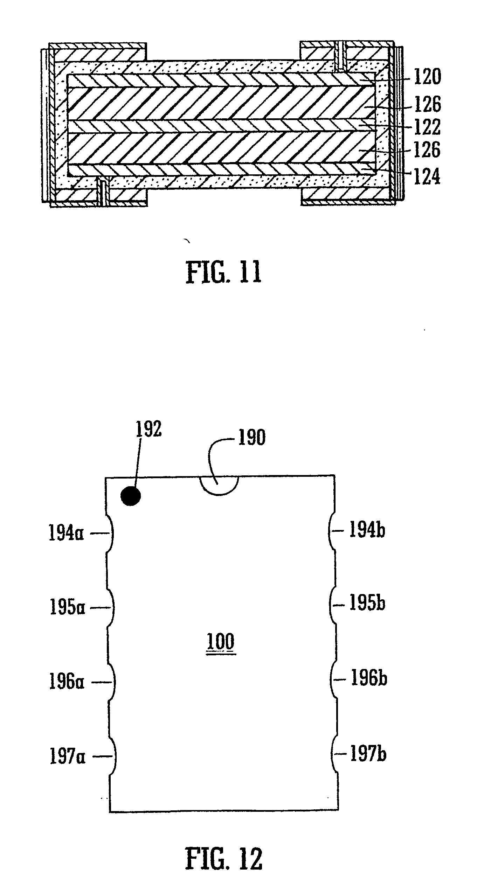

A further exemplary embodiment, as illustrated in FIG. 11, employs multiple layers of PTC material in the production of the PTC device instead of a single layer of PTC material. In this device, the single layer of PTC material sandwiched between two layers of metal (electrodes) is replaced by a laminar structure comprising three electrodes 120, 122, 124 interleaved with two layers of PTC material 126, 128. The remaining features and the method of manufacture are substantially unchanged.

This further embodiment in effect provides two PTC devices in series, with the middle electrode acting as a common electrode to the first device, comprising the top electrode and top layer of PTC material, and the second device comprising the bottom electrode and bottom layer of PTC material. It is believed that this multilayer structure provides a series combined PTC device having a higher breakdown voltage than would be achievable with a single PTC device.

An exemplary multi device package configuration is illustrated in FIG. 12, comprising a plurality of devices, of the type illustrated in FIGS. 9, 10 or 11, which may be fabricated in a matrix using the processes described above. The exemplary package 100 show comprises four individual devices, although the exact number of devices can be altered depending on circumstances. Each of the individual PTC devices in the package 100 has pairs of terminals provided on the underside of the package 100 adjacent to the insulated plated channels 194a, 194b; 195a, 195b; 196a, 196b, 197a, 197b to which electrical connections may be made. The package 100 may readily be structured or configured to resemble an integrated circuit structure for subsequent use by pick and place machines. Apart from appropriately dimensioning the package 100 and positioning the plated channels to represent appropriate IC sizing and connections, additional features may be included during the manufacturing process. For example, a notch 190 may be provided in the top center of the package 100 to identify the position of the top of the device. Similarly, a small dot 192 may be provided in the top left hand corner of the package to identify the top left hand corner of the resulting device. These additional features may be provided using conventional PCB techniques including etching as integral steps within the manufacture of the matrix described above before singulation.

The resulting IC type device may be readily modified for use as a dual in-line package (DIP) by appropriate fixing of a lead frame.

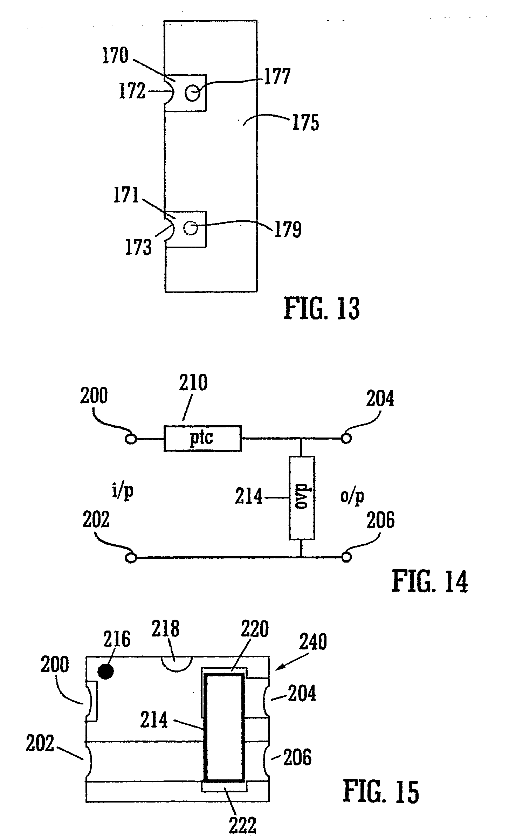

Although DIP packages are popular, in circumstances where board space is at a premium, single in-line packages (SIP) are preferred. The present invention may be readily adapted for use as a SIP package by providing paired terminals for connecting to each PTC device along one side of the package rather than on opposing sides of the device, for example as shown in the embodiment of FIG 13. In particular, as shown, a SIP package 175 has two terminals 170, 171, with each terminal connecting to a laminar electrode of a PTC device encapsulated within the device. The two terminals 170, 171 are arranged along the same device edge. Plated through-hole external interconnections 172, 173 (formed prior to singulation from a matrix structure described above) provide electrical connections between the top and bottom surfaces of the terminals. As described previously, the through-hole interconnections 172, 173 are in effect insulated conductive channels that provide external interconnections that pass through the PTC material. One of the terminals 170 connects with a first laminar electrode by means of a first blind micro-via 177 (as previously described) on the top surface of the device, whereas the other terminal 171 connects with the second laminar electrode by means of a second blind micro-via 179 (shown in dashed outline) on the bottom surface of the device. The component may be used as a leaded device by attachment of a lead frame along the edge with the terminals. In either case, the component is not limited to single devices, and it will be appreciated that a SIP component may be manufactured having a plurality of devices, with each device having two terminals disposed along an edge of the component. Moreover, it will be appreciated that the exact number of PTC devices for a particular component is decided by the number of PTC devices grouped together as a single component during singulation of the matrix described above. However, to prevent cross effects between adjoining devices, separation of the electrodes in the first and second metal layers is required.

Depending on the application, the individual characteristics of the devices may be equivalent or different. Different characteristics may be achieved by having differently sized electrodes, which may be effected at the previously described stage of defining singulation references.

As the PTC devices described herein are manufactured using conventional PCB techniques, the resulting devices may be used as miniature printed circuit boards onto which further circuit protection devices, for example a battery charge controller or an over-voltage protection device, such as a gas discharge tube, a thyristor or a metal oxide varistor (MOV) may be fixed, for example by direct soldering to the terminals, to provide a circuit protection module. An exemplary input protection circuit is shown in FIG. 14, comprising a PTC device 210 providing over-current protection, in series with an incoming line 200 followed by an over-voltage protection device 214, for example a thyristor, MOV, or gas discharge tube (GDT), in parallel with the outputs 204. The circuit of FIG. 14 may be manufactured by singulating a device from the previously described matrix to provide a PTC device having an input terminal 200 on one side of the device and an output terminal 204 on the opposing side of the device. A track may also be provided in the same process used to define the terminals to provide a direct electrical connection between the second input line 202 and the output 206.

The circuit of FIG. 14 may be packaged as a component 240 of the type illustrated in FIG. 15. The top surface of the component 240 is suitably configured, as shown in FIG. 15, such that the output terminals on the top surface of the device are configured as terminal pads 220, 222 to which the voltage protection device 214 is electrically connected. The voltage protection device 214 may be fixed to the pads 220, 224 by means such as pre-placed solder paste (which may be then reflowed) or a conductive epoxy. The resulting component 240 may be used as an SMT line protection device, with the terminals underlying the device (or plated channels\notches at the sides) providing SMT connection points. Additionally, as described above, suitable device markings may be included to aid orientation of the device. For example, a notch 218 may be provided in the top center of the component 240 to identify the top of the component. Similarly, a small dot 216 may be provided in a pre-selected corner of the component 240 for orientation purposes.

A drawback of existing PTC devices is that the effective area of the PTC material limits the trip currents of the devices. However, as circuit board space is generally at a premium, designers are reluctant to use devices having large device footprints. One solution to this problem is to provide PTC devices in a parallel configuration using a multilayer device construction. There has been a constant effort in the art to reduce the costs and to increase the efficiencies of manufacturing such multilayer devices.

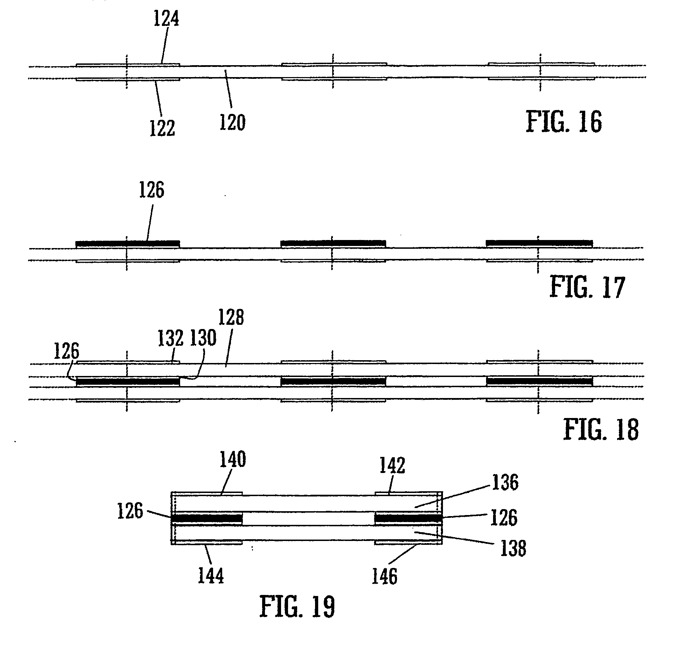

The matrix construction of the present invention facilitates a simple and efficient method of providing two or more devices in parallel in a quasi-multilayer construction. A side view of a section of a matrix of devices (of the symmetrical type shown in FIG. 9) is illustrated in FIG. 16. (The internal construction of the device is not shown for ease of explanation, with the vertical dashed lines representing points along which devices would be singulated equating to the locations of the insulated plated through-hole external interconnections of FIG. 9). Each of the individual devices of the matrix has four terminals defined to provide device symmetry when singulated. The method commences with the placing of a first matrix of devices 120 in a suitable jig or fixture (not shown). Solder paste 126 or other conductive fixing/adhesive material (e.g. conductive glue) is applied to the terminal areas 124 on the top surface of the matrix as shown in FIG. 17. A second matrix of devices 128 having a matching arrangement of terminals areas 130 on its underside is then placed on top of the first matrix as shown in FIG. 18. In the case of using solder paste, the entire arrangement is then placed in a reflow oven to cause the solder paste to flow. When cooled the, the two matrices are held together in a double-decked or duplicate matrix structure by the solder material, which electrically connects the terminals areas of the two matrices. It will be appreciated that when the resulting duplex matrix is singulated, the singulated devices, as shown in FIG. 19, are in effect two devices 136, 138 connected in parallel with the terminals 140, 142 on the upper surface of the top device providing one pair of terminals and the terminals on the lower surface of the bottom device providing a corresponding pair of terminals 144, 146 on the bottom surface. Each of the top terminals 140, 142 is electrically connected to its respective bottom terminal 144, 146 by respective insulated plated channels (as described previously and shown in dashed outline in FIG. 19) in cooperation with the terminals 124, 130 and solder material 126. This method of manufacturing devices in parallel is not limited to the use of two matrices, several matrices may be joined concurrently. However, as the number of matrices increases, practical difficulties arise in causing the solder paste to reflow correctly. This difficulty may be overcome if a conductive epoxy or other material is used in place of the solder paste.

Although the present invention has been described with reference primarily to an active material of the PTC type, it will be appreciated that the manufacturing process of the present invention may be advantageously applied to other active polymer materials and PTC materials and also to other materials including dielectrics, resistive, magnetic and semiconductor materials.

Although the present invention has been described with reference to commencement of manufacture from a laminated sheet of electronically active (e.g. PTC) material sandwiched between a first layer of metal and a second layer of metal, the method may commence with a layer of electronically active (e.g. PTC) material upon which metal foils may be placed, or metal layers deposited (e.g. by plating) as part of the manufacturing process described herein.

## Claims

1. A method of manufacturing an electronic device from a structure comprising at least one layer of device material (16) sandwiched between a first layer of metal (12) and a second layer of metal (14), comprising the steps of:
forming a first aperture (30) through the first layer of metal, the device material, and
the second layer of metal,
applying a first layer (48) of insulating material (40) to the first metal layer,
insulating the walls of the first aperture,
providing a third metal layer on the first layer of insulating material,
forming a second aperture (60) with a diameter smaller than the first aperture within the region defined by the insulative material in the first aperture,
providing a first electrical interconnection (68) between the top of the third metal layer and bottom surfaces of the second metal layer of the device through the second aperture,
forming a blind opening (70) through the third metal layer to the first metal layer, plating the surfaces of the third metal layer, the second metal layer, the second aperture and the blind opening
creating an electrical interconnection (84) between the third metal layer and the first metal layer, selectively removing metal from the third metal layer to define first (90) and second terminals (92), wherein the first terminal (90) includes the electrical interconnection created between the third metal layer and the first metal layer and the second terminal (92) includes the plated second aperture, (68) and the second electrode area (92).

2. A method of manufacturing an electronic device according to claim 1, wherein said step of insulating the walls of the first aperture is performed at least in part by the step of applying the first layer of insulating material (40) to the first metal layer.

3. A method of manufacturing an electronic device according to claim 1 or claim 2. comprising the further steps of: (42)
applying a second layer of insulating material (42) on the second metal layer (14), and
providing a fourth metal layer (50) on the second layer of insulating material before forming the second aperture.

4. A method of manufacturing an electronic device according to claim 3. wherein said step of insulating the walls of the first aperture is performed at least in part by the step of applying the second layer of insulating material to the second metal layer (14).

5. A method of manufacturing an electronic device according to claim 4, comprising the further steps of:
forming a third aperture, in advance of the application of the insulating layers, through the first metal layer, at least one layer of device material, and the second metal layer,
forming a fourth aperture within the region defined by the third aperture, and
plating the fourth aperture to provide a second electrical interconnection between the top and bottom surfaces of the device.

6. A method of manufacturing an electronic device according to claim 5, comprising the additional steps of creating an electrical interconnection between the fourth metal layer and the second metal layer, selectively removing material from the fourth metal layer to define third and fourth terminal areas, wherein the third terminal includes the fourth aperture and the fourth terminal includes the electrical interconnection created between the fourth metal layer and the second metal layer.

7. A method of manufacturing an electronic a device according to claim 1. wherein the first and third apertures are formed at opposing ends of the device.

8. A method of manufacturing an electronic device according to claim 1, wherein the steps of applying a first layer of insulating material to the first metal layer and providing a third metal layer on the first layer of insulating material and/or the steps of applying a second layer of insulating material to the second metal layer and providing a fourth metal layer on the second layer of insulating material are performed in a single step by the application of a resin clad metal.

9. A method of manufacturing an electronic device according to anyone of claims 1 to 8, wherein said structure comprising at least one layer of device material sandwiched between a first layer of metal and a second layer of metal is a multi layer structure comprising alternating layers of device material and metal.

10. A method of manufacturing an electronic device according to claim 1, wherein the device is a PTC device and the device material is a PTC material.

11. An electronic device obtained with the method of claim1 and comprising;
a first metal layer(12),
a second metal layer (14),
at least one layer of device material (16) sandwiched between the first metal layer (12) and the second metal layer (14) which function as electrodes for the device material,
a first terminal (90) for providing a first electrical connection to the device,
a second terminal (92) for providing a second electrical connection to the device,
wherein the first terminal (90) is electrically connected to the first metal layer (12) and the second terminal (92) is insulated from the first metal layer (12) and electrically connected to the second metal layer by a conductive channel (68) which passes through and is insulated from the first metal layer and device material (16).

12. An electronic device according to claim 11, wherein the second terminal is insulated from the first metal layer by a first layer of insulating material (40).

13. An electronic device according to claim 13. wherein said first layer of insulating material (40) substantially covers said first layer of metal (12).

14. An electronic device according to claim 14, further comprising a third layer of metal disposed on the first layer of insulating material (40) and where said third layer is divided by an isolation area to provide the first terminal (90) and the second terminal (92).

15. An electronic device according to anyone of claims 11 to 14, further comprising
a third terminal for providing a third electrical connection to the device.
a fourth terminal for providing a fourth electrical connection to the device,
wherein the fourth terminal is electrically connected to the second metal layer and the third terminal is insulated from the second metal layer and electrically connected to the first metal layer by a second conductive channel which passes through and is insulated from the second metal layer and device material.

16. An electronic device according to claim 15, wherein the third terminal is insulated from the second metal layer by a second layer of insulating material.

17. An electronic device according to claim 16, wherein said second layer of insulating material substantially covers said second layer of metal (14).

18. An electronic device according to anyone of claims 15 to 17, wherein the fourth terminal is electrically connected to the second metal layer by an interconnect formed through said second layer of insulating material.

19. An electronic device according to anyone of claims 15 to 18, wherein the first conductive channel or the second conductive channel is provided at one end of the device.

20. An electronic device according to anyone of claims 15 to 19. wherein the first conductive channel and second conductive channel are located at opposing ends of the device.

21. An electronic device according to claim 11, wherein said at least one layer of device material (16) comprises alternating layers of device material and metal.

22. An electronic device according to anyone of claims 15 to 21. wherein the first and/or second conductive channel comprise a metal plated channel.

23. An electronic device according to anyone of claims 11 to 24, wherein said device is a PTC device and said device material (16) is a PTC material.

24. A method of manufacturing a matrix of electronic devices, the individual electronic devices having a structure according to anyone of claims 11 to 23, from a structure comprising at least one layer of device material (16) sandwiched between a first layer of metal (12) and a second layer of metal (14), comprising the steps of:
forming a first array of apertures (30) through the first layer of metal, the device material, and the second layer of metal,
applying a first layer of insulating material (40) to the first metal layer,
insulating the walls of the first array of apertures,
providing a third metal layer (48) on the first layer of insulating material,
forming a second array of apertures (62) with a diameter smaller than the first aperture such that each aperture of the second array is positioned within the region defined by the insulating material in an aperture from the first array of apertures,
providing electrical interconnections (66) between the top and bottom surfaces of the matrix through the second array of apertures, forming an array of blind openings (70) through the third metal layer to the first metal layer, plating the surfaces of the third metal layer, the second metal layer, the second array of aperture and the blind openings, creating electrical interconnections (84) between the third metal
layer and the first metal layer, (90) (92)
selectively removing metal from the third metal layer to define first (90), and second terminals (92), for each device of the matrix, wherein each first terminal (90) includes an electrical interconnection between the third metal layer and the first metal layer and each second terminal (62) includes an insulated electrical interconnection between the top and bottom surfaces of the device.

25. A method of manufacturing a matrix of clectronic devices according to claim 24 comprising the additional step of joining a second matching matrix of electronic devices to the matrix such that terminals of adjoining faces of each matrix are aligned and elecuically connected.

26. A matrix of electronic devices obtained by the method of claim 24, the matrix comprising an array of electronic devices(12) according to anyone of claims 1 1 to 23 wherein the devices have a common first metal layer (12) second metal layer (14), and layer of device material (16), with a first array of terminals (90), for providing electrical connections to individual devices of the matrix, and
a second array of terminals (92), for providing electrical connections to individual devices of the matrix, wherein the first array of terminals are electrically connected to the first metal layer and the second array of terminals are insulated from the first metal layer and electrically connected to the second metal layer by conductive channels (68) which pass through and are insulated from the first metal layer and device material.

## Patentansprüche

1. Verfahren zur Herstellung eines elektronischen Bauelements aus einer Struktur mit mindestens einer Schicht aus Bauelementmaterial (16), die zwischen einer ersten Schicht aus Metall (12) und einer zweiten Schicht aus Metall (14) angeordnet ist, mit den Schritten:
Bilden einer ersten Öffnung (30) durch die erste Schicht aus Metall, das Bauelementmaterial und die zweite Schicht aus Metall,
Aufbringen einer ersten Schicht (48) aus Isoliermaterial (40) auf die erste Metallschicht,
Isolieren der Wände der ersten Öffnung,
Bereitstellen einer dritten Metallschicht auf der ersten Schicht aus Isoliermaterial,
Bilden einer zweiten Öffnung (60) mit einem kleineren Durchmesser als die erste Öffnung in dem durch das Isoliermaterial in der ersten Öffnung festgelegten Bereich,
Bereitstellen einer ersten elektrischen Verbindung (68) zwischen der Oberseite der dritten Metallschicht und der Unterseite der zweiten Metallschicht des Bauelements durch die zweite Öffnung,
Bilden einer Blindöffnung (70) durch die dritte Metallschicht zur ersten Metallschicht, Plattieren der Oberflächen der dritten Metallschicht, der zweiten Metallschicht, der zweiten Öffnung und der Blindöffnung, Erzeugen einer elektrischen Verbindung (84) zwischen der dritten Metallschicht und der ersten Metallschicht,
selektives Entfernen von Metall von der dritten Metallschicht, um einen ersten (90) und einen zweiten Anschluß (92) festzulegen, wobei der erste Anschluß (90) die elektrische Verbindung aufweist, die zwischen der dritten Metallschicht und der ersten Metallschicht erzeugt ist, und der zweite Anschluß (92) die plattierte zweite Öffnung, (68) und die zweite Elektrodenfläche (92) aufweist.

2. Verfahren zur Herstellung eines elektronischen Bauelements nach Anspruch 1, wobei der Schritt des Isolierens der Wände der ersten Öffnung mindestens teilweise durch den Schritt des Aufbringens der ersten Schicht aus Isoliermaterial (40) auf die erste Metallschicht durchgeführt wird.

3. Verfahren zur Herstellung eines elektronischen Bauelements nach Anspruch 1 oder Anspruch 2, ferner mit den Schritten:
Aufbringen einer zweiten Schicht aus Isoliermaterial (42) auf die zweite Metallschicht (14), und
Bereitstellen einer vierten Metallschicht (50) auf der zweiten Schicht aus Isoliermaterial vor Bilden der zweiten Öffnung.

4. Verfahren zur Herstellung eines elektronischen Bauelements nach Anspruch 3, wobei der Schritt des Isolierens der Wände der ersten Öffnung mindestens teilweise durch den Schritt des Aufbringens der zweiten Schicht aus Isoliermaterial auf die zweite Metallschicht (14) durchgeführt wird.

5. Verfahren zur Herstellung eines elektronischen Bauelements nach Anspruch 4 mit den weiteren Schritten:
vor dem Aufbringen der Isolierschichten erfolgendes Bilden einer dritten Öffnung durch die erste Metallschicht, mindestens eine Schicht aus Bauelementmaterial und die zweite Metallschicht,
Bilden einer vierten Öffnung in dem durch die dritte Öffnung festgelegten Bereich, und
Plattieren der vierten Öffnung, um eine zweite elektrische Verbindung zwischen der Ober- und Unterseite des Bauelements bereitzustellen.

6. Verfahren zur Herstellung eines elektronischen Bauelements nach Anspruch 5 mit den zusätzlichen Schritten: Erzeugen einer elektrischen Verbindung zwischen der vierten Metallschicht und der zweiten Metallschicht, selektives Entfernen von Material von der vierten Metallschicht, um eine dritte und eine vierte Anschlußfläche festzulegen, wobei der dritte Anschluß die vierte Öffnung aufweist und der vierte Anschluß die elektrische Verbindung aufweist, die zwischen der vierten Metallschicht und der zweiten Metallschicht erzeugt ist.

7. Verfahren zur Herstellung eines elektronischen Bauelements nach Anspruch 1, wobei die erste und dritte Öffnung an gegenüberliegenden Enden des Bauelements gebildet werden.

8. Verfahren zur Herstellung eines elektronischen Bauelements nach Anspruch 1, wobei die Schritte des Aufbringens einer ersten Schicht aus Isoliermaterial auf die erste Metallschicht und des Bereitstellens einer dritten Metallschicht auf der ersten Schicht aus Isoliermaterial und/oder die Schritte des Aufbringens einer zweiten Schicht aus Isoliermaterial auf die zweite Metallschicht und des Bereitstellens einer vierten Metallschicht auf der zweiten Schicht aus Isoliermaterial in einem einzelnen Schritt durch das Aufbringen eines Harzüberzugmaterials durchgeführt werden.

9. Verfahren zur Herstellung eines elektronischen Bauelements nach einem der Ansprüche 1 bis 8, wobei die Struktur mit mindestens einer Schicht aus Bauelementmaterial, die zwischen einer ersten Schicht aus Metall und einer zweiten Schicht aus Metall angeordnet ist, eine Mehrschichtstruktur mit abwechselnden Schichten aus Bauelementmaterial und Metall ist.

10. Verfahren zur Herstellung eines elektronischen Bauelements nach Anspruch 1, wobei das Bauelement ein PTC- (Kaltleiter-) Bauelement und das Bauelementmaterial ein PTC-Material ist.

11. Elektronisches Bauelement, das mit dem Verfahren nach Anspruch 1 erhalten wird und aufweist:
eine erste Metallschicht (12),
eine zweite Metallschicht (14),
mindestens eine Schicht aus Bauelementmaterial (16), die zwischen der ersten Metallschicht (12) und der zweiten Metallschicht (14) angeordnet ist, die als Elektroden für das Bauelementmaterial fungieren,
einen ersten Anschluß (90) zum Bereitstellen einer ersten elektrischen Verbindung mit dem Bauelement,
einen zweiten Anschluß (92) zum Bereitstellen einer zweiten elektrischen Verbindung mit dem Bauelement,
wobei der erste Anschluß (90) mit der ersten Metallschicht (12) elektrisch verbunden ist und der zweite Anschluß (92) von der ersten Metallschicht (12) isoliert und mit der zweiten Metallschicht durch einen leitenden Kanal (68) elektrisch verbunden ist, der die erste Metallschicht und das Bauelementmaterial (16) durchläuft und davon isoliert ist.

12. Elektronisches Bauelement nach Anspruch 11, wobei der zweite Anschluß von der ersten Metallschicht durch eine erste Schicht aus Isoliermaterial (40) isoliert ist.

13. Elektronisches Bauelement nach Anspruch 13, wobei die erste Schicht aus Isoliermaterial (40) die erste Schicht aus Metall (12) im wesentlichen bedeckt.

14. Elektronisches Bauelement nach Anspruch 14, ferner mit einer dritten Schicht aus Metall, die auf der ersten Schicht aus Isoliermaterial (40) angeordnet ist, und wobei die dritte Schicht durch eine Isolationsfläche geteilt ist, um den ersten Anschluß (90) und den zweiten Anschluß (92) bereitzustellen.

15. Elektronisches Bauelement nach einem der Ansprüche 11 bis 14, ferner mit:
einem dritten Anschluß zum Bereitstellen einer dritten elektrischen Verbindung mit dem Bauelement,
einem vierten Anschluß zum Bereitstellen einer vierten elektrischen Verbindung mit dem Bauelement,
wobei der vierte Anschluß mit der zweiten Metallschicht elektrisch verbunden ist und der dritte Anschluß von der zweiten Metallschicht isoliert und mit der ersten Metallschicht durch einen zweiten leitenden Kanal elektrisch verbunden ist, der die zweite Metallschicht und das Bauelementmaterial durchläuft und davon isoliert ist.

16. Elektronisches Bauelement nach Anspruch 15, wobei der dritte Anschluß von der zweiten Metallschicht durch eine zweite Schicht aus Isoliermaterial isoliert ist.

17. Elektronisches Bauelement nach Anspruch 16, wobei die zweite Schicht aus Isoliermaterial die zweite Schicht aus Metall (14) im wesentlichen bedeckt.

18. Elektronisches Bauelement nach einem der Ansprüche 15 bis 17, wobei der vierte Anschluß mit der zweiten Metallschicht durch eine Verbindung elektrisch verbunden ist, die durch die zweite Schicht aus Isoliermaterial gebildet ist.

19. Elektronisches Bauelement nach einem der Ansprüche 15 bis 18, wobei der erste leitende Kanal oder der zweite leitende Kanal an einem Ende des Bauelements vorgesehen ist.

20. Elektronisches Bauelement nach einem der Ansprüche 15 bis 19, wobei der erste leitende Kanal und zweite leitende Kanal an gegenüberliegenden Enden des Bauelements liegen.

21. Elektronisches Bauelement nach Anspruch 11, wobei mindestens eine Schicht aus Bauelementmaterial (16) abwechselnde Schichten aus Bauelementmaterial und Metall aufweist.

22. Elektronisches Bauelement nach einem der Ansprüche 15 bis 21, wobei der erste und/oder zweite leitende Kanal einen metallplattierten Kanal aufweisen.

23. Elektronisches Bauelement nach einem der Ansprüche 11 bis 24, wobei das Bauelement ein PTC- (Kaltleiter-) Bauelement und das Bauelementmaterial (16) ein PTC-Material ist.

24. Verfahren zur Herstellung einer Matrix elektronischer Bauelemente, wobei die einzelnen elektronischen Bauelemente eine Struktur nach einem der Ansprüche 11 bis 23 haben, aus einer Struktur mit mindestens einer Schicht aus Bauelementmaterial (16), die zwischen einer ersten Schicht aus Metall (12) und einer zweiten Schicht aus Metall (14) angeordnet ist, mit den Schritten:
Bilden einer ersten Anordnung von Öffnungen (30) durch die erste Schicht aus Metall, das Bauelementmaterial und die zweite Schicht aus Metall,
Aufbringen einer ersten Schicht aus Isoliermaterial (40) auf die erste Metallschicht,
Isolieren der Wände der ersten Anordnung von Öffnungen,
Bereitstellen einer dritten Metallschicht (48) auf der ersten Schicht aus Isoliermaterial,
Bilden einer zweiten Anordnung von Öffnungen (62) mit einem kleineren Durchmesser als die ersten Öffnungen, so daß jede Öffnung der zweiten Anordnung in dem Bereich positioniert ist, der durch das Isoliermaterial in einer Öffnung aus der ersten Anordnung von Öffnungen festgelegt ist,
Bereitstellen elektrischer Verbindungen (66) zwischen der Ober- und Unterseite der Matrix durch die zweite Anordnung von Öffnungen, Bilden einer Anordnung von Blindöffnungen (70) durch die dritte Metallschicht zur ersten Metallschicht, Plattieren der Oberflächen der dritten Metallschicht, der zweiten Metallschicht, der zweiten Anordnung von Öffnungen und der Blindöffnungen, Erzeugen elektrischer Verbindungen (84) zwischen der dritten Metallschicht und der ersten Metallschicht,
selektives Entfernen von Metall von der dritten Metallschicht, um einen ersten (90) und einen zweiten Anschluß (92) für jedes Bauelement der Matrix festzulegen, wobei jeder erste Anschluß (90) eine elektrische Verbindung zwischen der dritten Metallschicht und der ersten Metallschicht aufweist und jeder zweite Anschluß (92) eine isolierte elektrische Verbindung zwischen der Ober- und Unterseite des Bauelements aufweist.

25. Verfahren zur Herstellung einer Matrix elektronischer Bauelemente nach Anspruch 24 mit dem zusätzlichen Schritt des Anfügens einer zweiten angepaßten Matrix elektronischer Bauelemente an die Matrix, so daß Anschlüsse angrenzender Flächen jeder Matrix ausgerichtet und elektrisch verbunden sind.

26. Matrix elektronischer Bauelemente, die durch das Verfahren nach Anspruch 24 erhalten wird, wobei die Matrix eine Anordnung elektronischer Bauelemente nach einem der Ansprüche 11 bis 23 aufweist, wobei die Bauelemente folgendes haben: eine gemeinsame erste Metallschicht (12), zweite Metallschicht (14) und Schicht aus Bauelementmaterial (16) mit einer ersten Anordnung von Anschlüssen (90) zum Bereitstellen elektrischer Verbindungen mit einzelnen Bauelementen der Matrix, und
einer zweiten Anordnung von Anschlüssen (92) zum Bereitstellen elektrischer Verbindungen mit einzelnen Bauelementen der Matrix, wobei die erste Anordnung von Anschlüssen mit der ersten Metallschicht elektrisch verbunden ist und die zweite Anordnung von Anschlüssen von der ersten Metallschicht isoliert und mit der zweiten Metallschicht durch leitende Kanäle (68) elektrisch verbunden ist, die die erste Metallschicht und das Bauelementmaterial durchlaufen und davon isoliert sind.

## Revendications

1. Procédé pour fabriquer un dispositif électronique à partir d'une structure comportant au moins une couche de matériau de dispositif (16) enserrée entre une première couche de métal (12) et une deuxième couche de métal (14), comportant les étapes consistant à :
former une première ouverture (30) à travers la première couche de métal, le matériau de dispositif, et la deuxième couche de métal,
appliquer une première couche (48) de matériau isolant (40) à la première couche métallique,
isoler les parois de la première ouverture,
agencer une troisième couche métallique sur la première couche de matériau isolant,
former une deuxième ouverture (60) ayant un diamètre plus petit que la première ouverture dans la région définie par le matériau isolant dans la première ouverture,
établir une première interconnexion électrique (68) entre la surface supérieure de la troisième couche métallique et la surface inférieur de la deuxième couche métallique du dispositif à travers la deuxième ouverture,
créer une interconnexion électrique (84) formant une ouverture borgne (70) à travers la troisième couche métallique jusqu'à la première couche métallique, plaquer les surfaces de la troisième couche métallique, de la deuxième couche métallique, de la deuxième ouverture et de l'ouverture borgne entre la troisième couche métallique et la première couche métallique,
retirer de manière sélective le métal de la troisième couche métallique pour définir des première (90) et deuxième (92) bornes, la première borne (90) incluant l'interconnexion électrique créée entre la troisième couche métallique et la première couche métallique et la deuxième borne (92) incluant la deuxième ouverture plaquée (68) et la seconde zone d'électrode (92).

2. Procédé de fabrication d'un dispositif électronique selon la revendication 1, dans lequel ladite étape d'isolation des parois de la première ouverture est effectuée au moins une partie par l'étape consistant à appliquer la première couche de matériau isolant (40) à la première couche métallique.

3. Procédé de fabrication d'un dispositif électronique selon la revendication 1 ou la revendication 2, comportant les étapes supplémentaires consistant à :
appliquer une deuxième couche de matériau isolant (42) sur la deuxième couche métallique (14), et
agencer une quatrième couche métallique (50) sur la deuxième couche de matériau isolant avant la formation de la deuxième ouverture.

4. Procédé de fabrication d'un dispositif électronique selon la revendication 3, dans lequel ladite étape d'isolation des parois de la première ouverture est effectuée au moins en partie par l'étape consistant à appliquer la deuxième couche de matériau isolant à la deuxième couche métallique (14).

5. Procédé de fabrication d'un dispositif électronique selon la revendication 4, comportant les étapes supplémentaires consistant à :
former une troisième ouverture, avant l'application des couches isolantes, à travers la première couche métallique, au moins une couche de matériau de dispositif, et la deuxième couche métallique,
former une quatrième ouverture dans la région définie par la troisième ouverture, et
plaquer la quatrième ouverture pour établir une seconde interconnexion électrique entre les surfaces supérieure et inférieure du dispositif.

6. Procédé de fabrication d'un dispositif électronique selon la revendication 5, comportant les étapes supplémentaires consistant à créer une interconnexion électrique entre la quatrième couche métallique et la deuxième couche métallique, retirer de manière sélective le matériau de la quatrième couche métallique pour définir des troisième et quatrième zones de borne, la troisième borne incluant la quatrième ouverture et la quatrième borne incluant une interconnexion électrique créée entre la quatrième couche métallique et la deuxième couche métallique.

7. Procédé de fabrication d'un dispositif électronique selon la revendication 1, dans lequel les première et troisième ouvertures sont formées sur des extrémités opposées du dispositif.

8. Procédé de fabrication d'un dispositif électronique selon la revendication 1, dans lequel les étapes d'application d'une première couche de matériau isolant sur la première couche métallique et de fourniture d'une troisième couche métallique sur la première couche de matériau isolant et/ou les étapes d'application d'une deuxième couche de matériau isolant sur la deuxième couche métallique et de fourniture d'une quatrième couche métallique sur la deuxième couche de matériau isolant sont effectuées en une étape unique par l'application d'un métal de gainage en résine.

9. Procédé de fabrication d'un dispositif électronique selon l'une quelconque des revendications 1 à 8, dans lequel ladite structure comportant au moins une couche de matériau de dispositif enserrée entre une première couche de métal et une deuxième couche de métal est une structure multicouche comportant des couches alternées de matériau de dispositif et de métal.

10. Procédé de fabrication d'un dispositif électronique selon la revendication 1, dans lequel le dispositif est un dispositif PTC et le matériau de dispositif est un matériau PTC.

11. Dispositif électronique obtenu à l'aide du procédé selon la revendication 1 et comportant :
une première couche métallique (12),
une deuxième couche métallique (14),
au moins une couche de matériau de dispositif (16) enserrée entre la première couche métallique (12) et la deuxième couche métallique (14) qui fonctionnent comme des électrodes pour le matériau de dispositif,
une première borne (90) pour établir une première connexion électrique avec le dispositif,
une deuxième borne (92) pour établir une deuxième connexion électrique avec le dispositif,
dans lequel la première borne (90) est connectée électriquement à la première couche métallique (12) et la deuxième borne (92) est isolée de la première couche métallique (12) et connectée électriquement à la deuxième couche métallique par un canal conducteur (68) qui passe à travers la première couche métallique et le matériau de disposition (16) et est isolée de ceux-ci.

12. Dispositif électronique selon la revendication 11, dans lequel la deuxième borne est isolée de la première couche métallique par une première couche de matériau isolant (40).

13. Dispositif électronique selon la revendication 13, dans lequel ladite première couche de matériau isolant (40) recouvre essentiellement ladite première couche de métal (12).

14. Dispositif électronique selon la revendication 14, comportant de plus une troisième couche de métal disposée sur la première couche de matériau isolant (40) et où ladite troisième couche est divisée par une zone isolante pour fournir la première borne (90) et la deuxième borne (92).

15. Dispositif électronique selon l'une quelconque des revendications 11 à 14, comportant de plus
une troisième borne pour établir une troisième connexion électrique avec le dispositif,
une quatrième borne pour établir une quatrième connexion électrique avec le dispositif,
dans lequel la quatrième borne est connectée électriquement à la deuxième couche métallique et la troisième borne est isolée de la deuxième couche métallique et connectée électriquement à la première couche métallique par un second canal conducteur qui passe à travers la deuxième couche métallique et le matériau de dispositif, et est isolée de ceux-ci.

16. Dispositif électronique selon la revendication 15, dans lequel la troisième borne est isolée de la deuxième couche métallique par une deuxième couche de matériau isolant.

17. Dispositif électronique selon la revendication 16, dans lequel la deuxième couche de matériau isolant recouvre essentiellement ladite deuxième couche de métal (14).

18. Dispositif électronique selon l'une quelconque des revendications 15 à 17, dans lequel la quatrième borne est connectée électriquement à la deuxième couche métallique par une interconnexion formée à travers ladite deuxième couche de matériau isolant.

19. Dispositif électronique selon l'une quelconque des revendications 15 à 18, dans lequel le premier canal conducteur ou le second canal conducteur est agencé sur une extrémité du dispositif.

20. Dispositif électronique selon l'une quelconque des revendications 15 à 19, dans lequel le premier canal conducteur et le second canal conducteur sont positionnés sur les extrémités opposées du dispositif.

21. Dispositif électronique selon la revendication 11, dans lequel ladite au moins une couche de matériau de dispositif (16) comporte des couches alternées de matériau de dispositif et de métal.

22. Dispositif électronique selon l'une quelconque des revendications 15 à 21, dans lequel les premier et/ou second canaux conducteurs comportent un canal plaqué de métal.

23. Dispositif électronique selon l'une quelconque des revendications 11 à 24, dans lequel ledit dispositif est un dispositif PTC et ledit matériau de dispositif (16) est un matériau PTC.

24. Procédé pour fabriquer une matrice de dispositifs électroniques, les dispositifs électroniques individuels ayant une structure selon l'une quelconque des revendications 11 à 23, à partir d'une structure comportant au moins une couche de matériau isolant (16) enserrée entre une première couche de métal (12) et une deuxième couche de métal (14), comportant les étapes consistant à :
former une première série d'ouvertures (30) à travers la première couche de métal, le matériel de dispositif, et la deuxième couche de métal,
appliquer une première couche de matériau isolant (40) à la première couche métallique,
isoler les parois de la première série d'ouvertures,
agencer une troisième couche métallique (48) sur la première couche de matériau isolant,
former une seconde série d'ouvertures (62) ayant un diamètre plus petit que les premières ouvertures, de sorte que chaque ouverture de la seconde série est positionnée dans la région définie par le matériau isolant dans une ouverture de la première série d'ouvertures,
établir des connexions électriques (66) entre les surfaces supérieure et inférieure de la matrice à travers la seconde série d'ouvertures, former une série d'ouvertures borgnes (70) à travers la troisième couche métallique jusqu'à la première couche métallique, plaquer les surfaces de la troisième couche métallique, de la deuxième couche métallique, de la seconde série d'ouvertures et des ouvertures borgnes, créer des interconnexions électriques (84) entre la troisième couche métallique et la première couche métallique,
retirer de manière sélective un métal de la troisième couche métallique pour définir des première (90) et deuxième (92) bornes pour chaque dispositif de la matrice, dans lequel chaque première borne (90) inclut une interconnexion électrique entre la troisième couche métallique et la première couche métallique et chaque deuxième borne (92) inclut une interconnexion électrique isolée entre les surfaces supérieure et inférieure du dispositif.

25. Procédé pour fabriquer une matrice de dispositifs électroniques selon la revendication 24, comportant l'étape supplémentaire consistant à raccorder une seconde matrice d'adaptation de dispositifs électroniques à la matrice de sorte que des bornes de faces attenantes de chaque matrice sont alignées et connectées électriquement.

26. Matrice de dispositifs électroniques obtenue par le procédé selon la revendication 24, la matrice comportant une série de dispositifs électroniques selon l'une quelconque des revendications 11 à 23, dans laquelle les dispositifs ont une première couche métallique commune (12), une deuxième couche métallique (14), et une couche de matériau de dispositif (16), avec une première série de bornes (90) pour établir des connexions électriques avec des dispositifs individuels de la matrice, et
une seconde série de bornes (92) pour établir des connexions électriques avec des dispositifs individuels de la matrice, dans laquelle la première série de bornes est électriquement connectée à la première couche métallique et la seconde série de bornes est isolée de la première couche métallique et connectée électriquement à la deuxième couche métallique par des canaux conducteurs (68) qui passent à travers la première couche métallique et le matériau de dispositif, et sont isolées de ceux-ci.
